# EUROPEAN PATENT SPECIFICATION

(11) **EP 3 343 611 B1**
(45) Date of publication and mention of the grant of the patent: **22.09.2021**
(21) Application number: 18150050.5
(22) Date of filing: 02.01.2018
(51) Int. Cl.: H01L 25/075, H01L 25/16

(54) **DISPLAY DEVICE**
ANZEIGEVORRICHTUNG
DISPOSITIF D'AFFICHAGE

(30) Priority: 03.01.2017 US 201762441579 P; 25.01.2017 US 201762450106 P; 09.05.2017 US 201715590030
(43) Date of publication of application: 04.07.2018
(73) Proprietor: InnoLux Corporation, Chu-Nan, Miao-Li County 35053 (TW)
(72) Inventor: Lee, Kuan-Feng, 35053 Miao-Li County (TW); Wu, Yu-Hsien, 35053 Miao-Li County (TW)
(74) Representative: 2K Patentanwälte Blasberg Kewitz & Reichel

(56) References cited:
- US-A1- 2014 138 646
- US-A1- 2014 367 705

## Description

### BACKGROUND

### 1. Technical Field

The present disclosure relates to a device, and particularly, relates to a display device.

### 2. Description of Related Art

Because light emitting diode (LED) display apparatuses have advantages such as active light emitting, high brightness, high contrast ratio, and low power consumption, in recent years, they have become one of technologies, which are vigorously developed, of new displays. To satisfy the requirement of high resolution, LED display apparatuses are developing towards the direction of being formed by an active element substrate and LEDs that have the micrometer size and are arranged in an array.
US2014138646(A1) discloses an organic light-emitting diode (OLED) display apparatus including a substrate, an insulation layer on the substrate, and an align mark formed of an insulation material, wherein an upper surface of the insulation layer contacts a lower surface of the align mark.
US2014367705(A1) discloses a light emitting device and methods of integrating micro LED devices into light emitting device are described. In an embodiment a light emitting device includes a reflective bank structure within a bank layer, and a conductive line atop the bank layer and elevated above the reflective bank structure. A micro LED device is within the reflective bank structure and a passivation layer is over the bank layer and laterally around the micro LED device within the reflective bank structure. A portion of the micro LED device and a conductive line atop the bank layer protrude above a top surface of the passivation layer.

### SUMMARY

The present disclosure provides a display device, which is capable of having a better accuracy of transferring display units onto a substrate and a less required time for transferring the display units during the fabrication. The inventive display panel is defined in claim 1. The dependent claims are directed towards preferred embodiments.

In one embodiment, the display device of the disclosure includes a substrate, a plurality of transistors, a plurality of display units, and a plurality of alignment marks. The substrate includes a display area and a non-display area adjacent to the display area. The plurality of transistors is disposed on the display area of the substrate. The plurality of display units is disposed on the display area of the substrate, and the plurality of display units is electrically connected to the plurality of transistors, respectively. The plurality of alignment marks is disposed on the substrate, wherein at least one of the plurality of alignment marks is disposed on the display area of the substrate.

In another embodiment, the display device of the disclosure includes a base substrate, a transistor, an alignment mark, and a display unit. The transistor is disposed on the base substrate. The alignment mark is disposed on the base substrate. The display unit is disposed on and electrically connected to the transistor, wherein the display unit is a micro display diode.

In order to make the aforementioned and other objectives and advantages of the present disclosure comprehensible, embodiments accompanied with figures are described in detail below.

### BRIEF DESCRIPTION OF THE DRAWINGS

Aspects of the disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a schematic top view of a carrier substrate having display devices of the disclosure.
FIG. 2 is a schematic top view illustrating a display device according to an embodiment of the disclosure
FIG. 3 is a schematic top view illustrating a display device according to another embodiment of the disclosure
FIG. 4 is a schematic top view illustrating a display device according to another embodiment of the disclosure
FIG. 5 is a schematic top view illustrating a display device according to another embodiment of the disclosure
FIG. 6 is a schematic cross-sectional view of a part of a display device according to an embodiment of the disclosure
FIG. 7 is a schematic cross-sectional view of a part of a display device according to another embodiment of the disclosure.
FIG. 8 is a schematic cross-sectional view of a part of a display device according to another embodiment of the disclosure.
FIG. 9 is a schematic cross-sectional view of a part of a display device according to an embodiment that is not part of the invention as claimed.
FIG. 10A is a schematic cross-sectional view of an intermediately stage in a manufacturing process of a display device according to a first embodiment of the disclosure.
FIG. 10B is a schematic plane view of the display device depicted in FIG. 10A.
FIG. 11A is a schematic cross-sectional view of a pick apparatus used in an intermediately stage in a manufacturing process of the display device according to the first embodiment of the disclosure.
FIG. 11B is a schematic plane view of the pick apparatus depicted in FIG. 11A.
FIG. 12A is a schematic cross-sectional view of an intermediately stage in a manufacturing process of the display device according to the first embodiment of the disclosure.
FIG. 12B is a schematic plane view of the display device depicted in FIG. 12A.
FIG. 13A is a schematic cross-sectional view of an intermediately stage in a manufacturing process of a display device according to a second embodiment of the disclosure.
FIG. 13B is a schematic plane view of the display device depicted in FIG. 13A.
FIG. 14A is a schematic cross-sectional view of a pick apparatus used in an intermediately stage in a manufacturing process of the display device according to the second embodiment of the disclosure.
FIG. 14B is a schematic plane view of the pick apparatus depicted in FIG. 14A.
FIG. 15A is a schematic cross-sectional view of an intermediately stage in a manufacturing process of the display device according to the second embodiment of the disclosure.
FIG. 15B is a schematic plane view of the display device depicted in FIG. 15A.
FIG. 16A is a schematic cross-sectional view of a pick apparatus used in an intermediately stage in a manufacturing process of the display device according to the second embodiment of the disclosure.
FIG. 16B is a schematic plane view of the pick apparatus depicted in FIG. 16A.
FIG. 17A is a schematic cross-sectional view of an intermediately stage in a manufacturing process of the display device according to the second embodiment of the disclosure.
FIG. 17B is a schematic plane view of the display device depicted in FIG. 17A.
FIG. 18A to FIG. 18D are schematic top views of a relative position between an alignment mark disposed on a display panel and an alignment mark disposed on a pick apparatus.
FIG. 19 is a schematic top view illustrating a display device according to another embodiment of the disclosure

### DESCRIPTION OF THE EMBODIMENTS

Reference will now be made in detail to the present preferred embodiments of the disclosure, examples of which are illustrated in the accompanying drawings. Wherever possible, the same reference numbers are used in the drawings and the description to refer to the same or like parts.

In the present specification, the description of forming another structure above or on a structure may include an embodiment of forming direct contact between the structure and the another structure, and may also include an embodiment of forming an additional structure between the structure and the another structure so that the structure may not get in direct contact with the another structure.

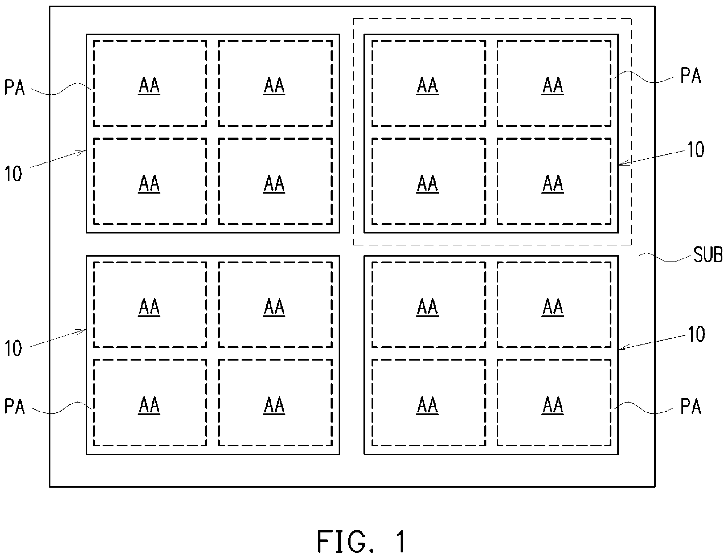

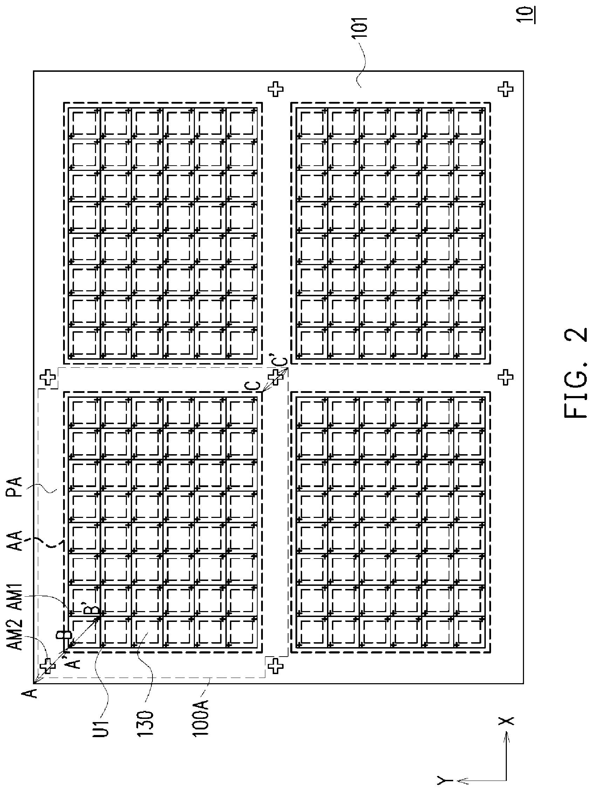

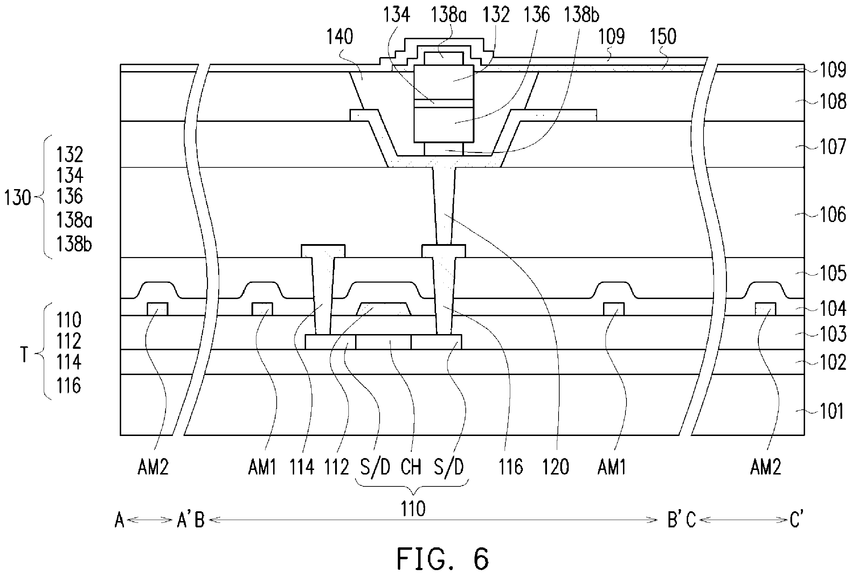

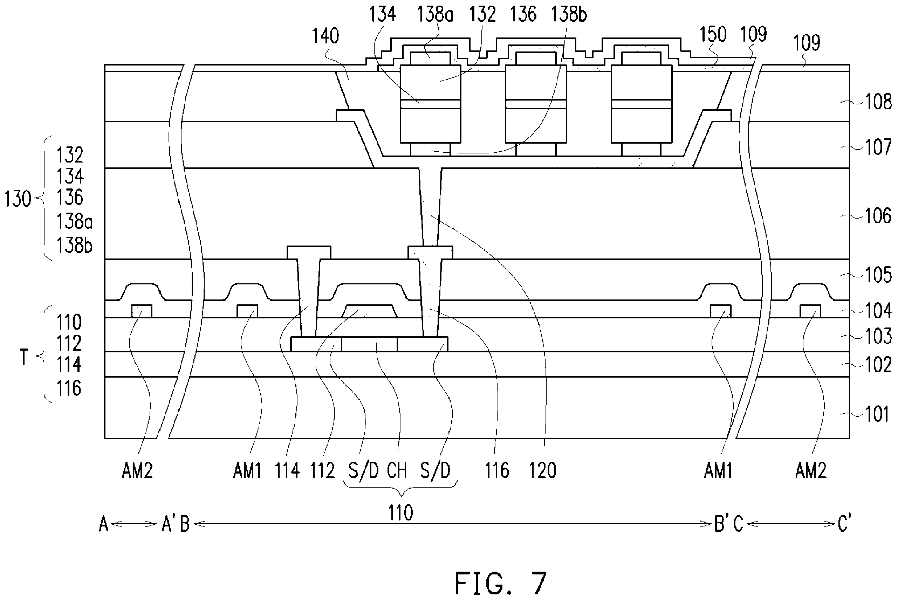

FIG. 1 is a schematic top view of a carrier substrate having display devices of the disclosure. FIG. 2 is a schematic top view illustrating a display device according to an embodiment of the disclosure, FIG, 6 is a schematic cross-sectional view of a part of a display device according to an embodiment of the disclosure. FIG. 7 is a schematic cross-sectional view of a part of a display device according to another embodiment of the disclosure. FIG. 6 and FIG. 7 illustrate the cross-sectional views of a part of the display device taken along section lines A-A', B-B' and C-C' depicted in FIG. 2.

Referring to FIG. 1 and FIG. 2, a carrier substrate SUB having display panels is provided. In the embodiment, the display panels can be display devices 10. In some embodiments, the carrier substrate SUB, for example, includes four of the display devices 10, and each of the display devices 10, for example, includes a substrate 101 having four alignment regions 100A for transferring display units. A material of the substrate 101 may be a single layer or a stack of one of glass, quartz, organic polymers (e.g., polyimide, polyethylene terephthalate, polycarbonate, PMMA etc.), opaque/reflective materials (e.g., conductive materials, metals, wafers, ceramics, etc.) and other applicable materials, or a stack or a mixture of the at least two above-mentioned materials, but the disclosure is not limited thereto. However, in other embodiments, the carrier substrate SUB may include less than four display devices or more than four display panels, and each display device may include less than or more than four regions for transferring display units, the disclosure is not limited thereto. For clarification, as the configurations of the alignment regions 100A in the display devices 10 are the same, the detailed structure of each display panel 10 will be elaborated by one alignment region 100A of one display device 10 in following descriptions.

In the embodiment, as shown in FIG. 2 and FIG. 6, the display device 10 has a display area AA, a non-display area PA adjacent to the display area AA. As shown in FIG. 2 and FIG. 6, the display device 10 includes a plurality of sub-pixel units U1 each having a transistor T and a display unit 130 disposed on the display area AA, a plurality of alignment marks AMI disposed on the display area AA and a plurality of alignment marks AM2 disposed on the non-display area PA. The display device 10 further includes scan lines and data lines (not shown), a buffer layer 102, a gate insulating layer 103, a plurality of insulating layers 104/105/106/107/108, a pixel electrode 120, a filling material 140, a conductive electrode 150, and a protection layer 109.

Referring to FIG. 2, the sub-pixel units U1 are disposed on the display area AA, and the sub-pixel units U1 are arranged in an array along an X-direction and a Y-direction. In the embodiment, the sub-pixel units U1 are arranged in a form of 6x8 array; however, people having ordinary skills in the pertinent art should understand that the array formed by the sub-pixel units U1 depicted in FIG. 2 is constituted by a plurality of sub-pixel units arranged in an array based on the demand, where the number of the sub-pixel units is not specifically limited in the disclosure. In FIG. 6, a cross-sectional view taken along the section line B-B' depicted in FIG. 2 of one sub-pixel unit U1 is illustrated, and cross-sectional views of the alignment marks AMI and the alignment marks AM2 taken along the section line A-A' and the section line C-C' depicted in FIG. 2 are illustrated, so that persons skilled in the art can understand the disclosure clearly. Furthermore, as shown in FIG. 2 and FIG. 6, it should be noted that each of the sub-pixel units U1 includes a transistor and a display element as illustrated in FIG. 6. However, the disclosure does not limit each sub-pixel unit U1 to include one transistor and/or one display unit, the numbers of the transistors and the display units are not limited. The numbers of the transistors and the display units can be one or more than one, and may be designated and selected based on the demand. For example, as shown in FIG. 7, the sub-pixel unit U1 may include one transistor T and three display units 130 electrically connected to the transistor T, wherein the display units 130 are electrically connected in series through the pixel electrode 120. On the other hand, in the disclosure, a number of the plurality of display units 130 is greater than a number of the plurality of alignment marks AMI disposed on the display area AA of the substrate 101.

Referring to FIG. 2 and 6, the buffer layer 102 is optionally disposed on the substrate 101. A material of the buffer layer 102 can includes, but not limited to, silicon oxide, silicon nitride, silicon oxynitride, or a stacked layer of the above materials.

In the embodiment, the transistor T is disposed on the substrate 101 and the buffer layer 102. In the embodiment, the transistor T includes a semiconductor layer 110, a gate electrode 112, a source/drain electrode 114 and a source/drain electrode 116. In the embodiment, the gate electrode 112 is located on the semiconductor layer 110. In detail, the semiconductor layer 110 includes a first region S/D, a second region S/D, and a channel region CH located between the first region S/D and the second region S/D. In the embodiment, a material of the semiconductor layer 110, for example, may be selectively a low temperature polysilicon semiconductor material, an amorphous silicon semiconductor material, an oxide semiconductor material, an organic semiconductor material, or other semiconductor materials. In consideration of electrical conductivity, the gate electrode 112 is often made of metal materials. However, the disclosure is not limited thereto. According to other embodiments of the disclosure, the gate electrode 112 can also be made of other conductive materials. The metal material includes, for example, conductive materials (such as an alloy, a metal nitride material, a metal oxide material, a metal oxynitride material, or other suitable materials), or a stacked layer containing the metallic material and any other conductive material.

The gate insulating layer 103 is disposed between the semiconductor layer 110 and the gate electrode 112, wherein the gate insulating layer 103 is conformally formed on and covers the semiconductor layer 110. A material of the gate insulating layer 103 can include an inorganic material (such as silicon oxide, silicon nitride, or silicon oxynitride), an organic material (such as polyimide resin, epoxy resin, or acrylic resin), or a stacked layer containing the insulating material and any other insulating material.

As shown to FIG. 6, the insulating layer 104 and the insulating layer 105 are disposed on the gate electrode 112, wherein the insulating layer 105 is located on the insulating layer 104. In detail, the insulating layer 104 and the insulating layer 105 are both used for protecting the gate electrode 112 from being damaged during the manufacturing process, wherein the insulating layer 105 can be further served as a passivation layer for provide a flattening function. The materials of the insulating layer 104 and insulating layer 105 can include an inorganic material (such as silicon oxide, silicon nitride, or silicon oxynitride), an organic material (such as polyimide resin, epoxy resin, or acrylic resin), or a stacked layer containing the insulating material and any other insulating material.

In the embodiment, the source/drain electrode 114 and the source/drain electrode 116 are disposed on the gate electrode 112. As shown in FIG. 6, the source/drain electrode 114 is physically connected to the first region S/D through a first via hole formed in the insulating layer 104 and the insulating layer 105; and similarly, the source/drain electrode 116 is physically connected to the second region S/D through a second via hole formed in the insulating layer 104 and the insulating layer 105. The materials of the source/drain electrode 114 and the source/drain electrode 116 can include metal materials (such as aluminium, molybdenum, titanium, gold indium, tin or a combination thereof), metal oxide or other semiconductor materials. As such, the transistor T includes at least the semiconductor layer 110, the gate electrode 112, the source/drain electrode 114, and the source/drain electrode 116.

Referring to FIG. 6, the insulating layer 106 and the insulating layer 107 are disposed on the transistor T, wherein the insulating layer 107 is located on the insulating layer 106. In detail, the insulating layer 107 and the insulating layer 106 are both used for protecting the transistor T from being damaged during the manufacturing process, wherein the insulating layer 107 can be further served as a passivation layer for provide a flattening function. The materials of the insulating layer 106 and insulating layer 107 can include an inorganic material (such as silicon oxide, silicon nitride, or silicon oxynitride), an organic material (such as polyimide resin, epoxy resin, or acrylic resin), or a stacked layer containing the insulating material and any other insulating material.

Referring to FIG. 6, the pixel electrode 120 is disposed on the transistor T and is electrically connected to the transistor T. In the embodiment, the pixel electrode 120 is physically connected to the source/drain electrode 116 of the transistor T through an opening formed in the insulating layer 106 and the insulating layer 107. In detail, the opening formed in the insulating layer 106 and the insulating layer 107 exposes a portion of the transistor T (e.g. a part of the source/drain electrode 116). The pixel electrode 120 fills up a part of the opening (e.g., the opening formed in the insulating layer 106) and covers a bottom surface and sidewalls of a part of the opening (e.g., the opening formed in the insulating layer 107), and the pixel electrode 120 extends to a surface of the insulating layer 107 opposite to the transistor T. In the embodiment, the pixel electrode 120 is served as a pixel electrode of the transistor T. A material of the pixel electrode 120 can include metal materials, such as aluminium, molybdenum, titanium, gold indium, tin or a combination thereof. In some embodiments, the materials of the source/drain electrode 114, the source/drain electrode 116 and the pixel electrode 120 can be the same or different, the disclosure is not limited thereto.

The insulating layer 108 is disposed on the insulating layer 107 and a portion of the pixel electrode 120, as shown in FIG. 6. In other words, a portion of the pixel electrode 120 is exposed by the insulating layer 108. A material of the insulation layer 108, for example, may be an inorganic material, an organic material, or a combination thereof, where the inorganic material, for example, is silicon oxide, silicon nitride, silicon oxynitride, or a stack layer of the foregoing at least two materials; the organic material, for example, is a macromolecular material, such as polyimide resin, epoxy resin, or acrylic resin. In the embodiment, the pixel electrode 120 and the insulating layer 108 together define an accommodated space for the display unit 130. In other words, the location of the accommodated space corresponds to the location of the pixel electrode 120.

Referring to FIG. 6, the display unit 130 is disposed on the transistor T and is electrically connected to the transistor T through the pixel electrode 120. In the embodiment, the display unit 130 includes a semiconductor layer of first conductivity type 132, an active layer 134, a semiconductor layer of second conductivity type 136, an electrode 138a, and an electrode 138b. In detail, the display unit 130 is disposed in the accommodated spaced formed by the first element 120 and the insulating layer 108, and the display unit 130 is electrically connected to the pixel electrode 120 via the electrode 138b, so that the transistor T can drive the display unit 130 through the pixel electrode 120. In one embodiment, the semiconductor layer of the first conductivity type 132 may be a n-type semiconductor layer, the active layer 134 may be a quantum-well structure layer, the semiconductor layer of the second conductivity type 136 may be a p-type semiconductor layer, the electrode 138a may be a n-type electrode, and the electrode 138b may be p-type electrode. However, the disclosure is not limited thereto. In another embodiment, the semiconductor layer of the first conductivity type 132 may be a p-type semiconductor layer, the active layer 134 may be a quantum-well structure layer, the semiconductor layer of the second conductivity type 136 may be a n-type semiconductor layer, the electrode 138a may be a p-type electrode, and the electrode 138b may be n-type electrode. The active layer 134 may be, for example, a multiple quantum-well structure layer. The display unit 130 is a light emitting diode (LED) like a LED with micrometer-level sizes (e.g. micro light emitting diode (micro LED); and as shown in FIG. 6, the display unit 130 is a vertical light emitting diode (LED), however, the disclosure is not limited thereto. In other embodiments, the display unit 130 may be a flip chip LED.

The filling material 140 fills the accommodated space and covers at least the side surfaces of the display unit 130. A material of the filling material 140 may, for example, include glue, resin, silicon oxide, silicon nitride or underfiller. In additional, the material of the filling material 140 may further include, but not limited to, a quantum dot material, a fluorescent powder material, a phosphor power material, or a combination thereof. In other embodiments, the filling material 140 may completely encapsulate the display unit 130.

Referring to FIG. 6, the conductive electrode 150 is disposed on the display unit 130, the filling material 140, and the insulating layer 108. In the embodiment, the conductive electrode 150 is conformally formed on the display unit 130, the filling material 140, and the insulating layer 108. The conductive electrode 150 receives a common voltage from an element (e.g., a transistor or a terminal pad electrically grounded) of a driving circuitry located on the non-display area PA, the driving circuitry may be selected based on the demand by persons skilled in the art and is not specifically limited in the disclosure, and thus are omitted from illustration herein. In certain embodiments, the conductive electrode 150 may be served as a common electrode of the transistor T. A material of the conductive electrode 150 may include metal materials, such as aluminium, molybdenum, titanium, gold indium, tin or a combination thereof. The materials of the conductive electrode 150 can be the same or different from that of the source/drain electrode 114, the source/drain electrode 116 and the pixel electrode 120; the disclosure is not limited thereto.

The protection layer 109 is disposed on the substrate 101. As shown in FIG. 6, the protection layer 109 is conformally formed on the insulating layer 108 and the conductive electrode 150. The protection layer 109 protects the display unit 130 and the conductive electrode 150 from being damaged during the manufacturing process. A material of the insulation layer 109, for example, may be an inorganic material, an organic material, or a combination thereof, where the inorganic material, for example, is silicon oxide, silicon nitride, silicon oxynitride, or a stack layer of the foregoing at least two materials; the organic material, for example, is a macromolecular material, such as polyimide resin, epoxy resin, or acrylic resin.

In some embodiments, the materials of the buffer layer 102, the insulating layer 103, the insulating layer 104, the insulating layer 105, the insulating layer 106, the insulating layer 107, the insulating layer 108, and the protection layer 109 can be the same or different from one another. The disclosure is not limited thereto.

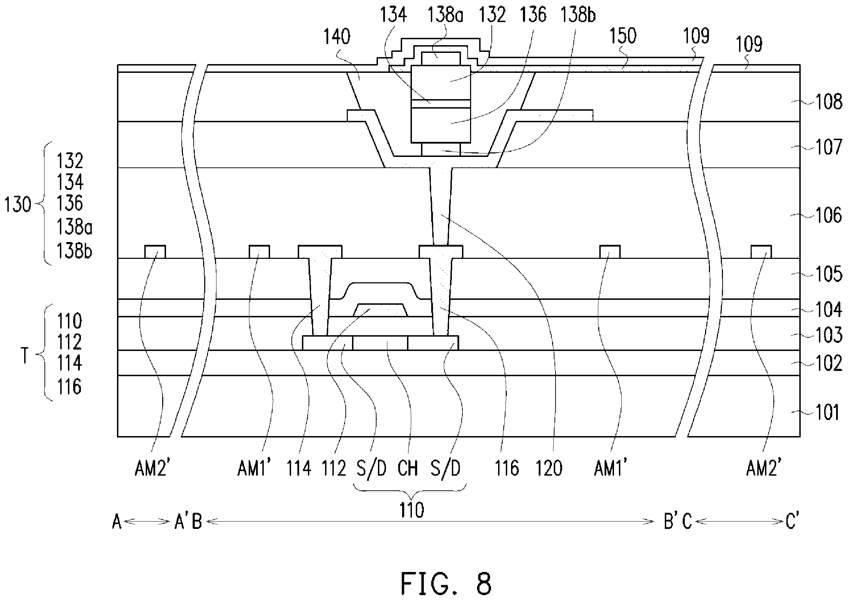

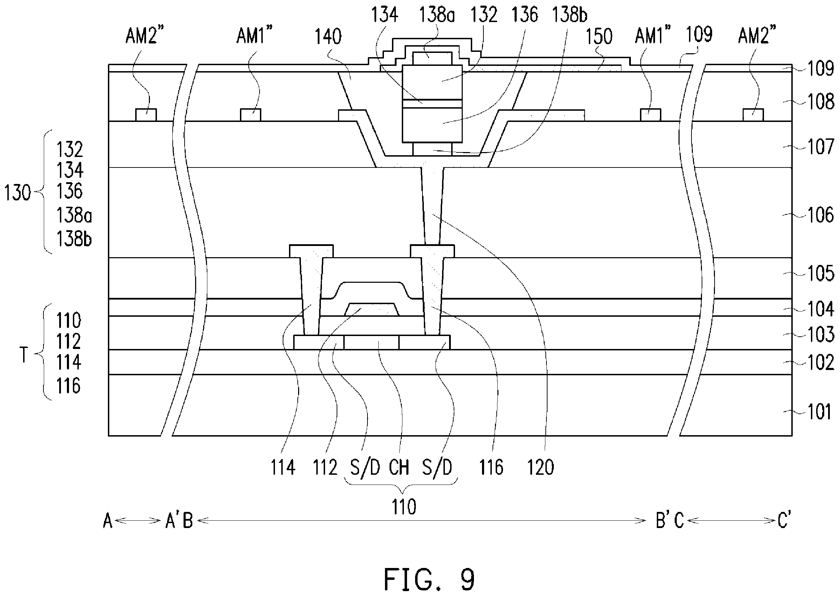

As shown in FIG. 2 and FIG. 6, the alignment marks AMI is located on the display area AA of the substrate 101, and the alignment marks AM2 is located on the non-display area PA of the substrate 101. In the embodiment, as shown in FIG. 6, the alignment marks AMI and the alignment marks AM2 are formed in the same layer as the gate electrode 112. In one embodiment, the alignment marks AMI' and the alignment marks AM2' are formed in the same layer as the first source/ drain electrode 114 and the source/drain electrode 116, as shown in FIG. 8. In another one embodiment that is not part of the invention as claimed, the alignment marks AM1" and the alignment marks AM2" are formed in the same layer as the pixel electrode 120, as shown in FIG. 9. The alignment marks AM1 and the alignment marks AM2 are not overlapped with the display unit 130.

Back to FIG. 2, each alignment region 100A has a pair of the alignment marks AM2 located at two different positions on the non-display area which are positioning along an extending direction of a diagonal line of the display area AA, and each sub-pixel unit U1 has a pair of the alignment marks AMI located at two different positions on the sub-pixel unit U1 which are positioning along an extending direction of a diagonal line of the sub-pixel unit U1.

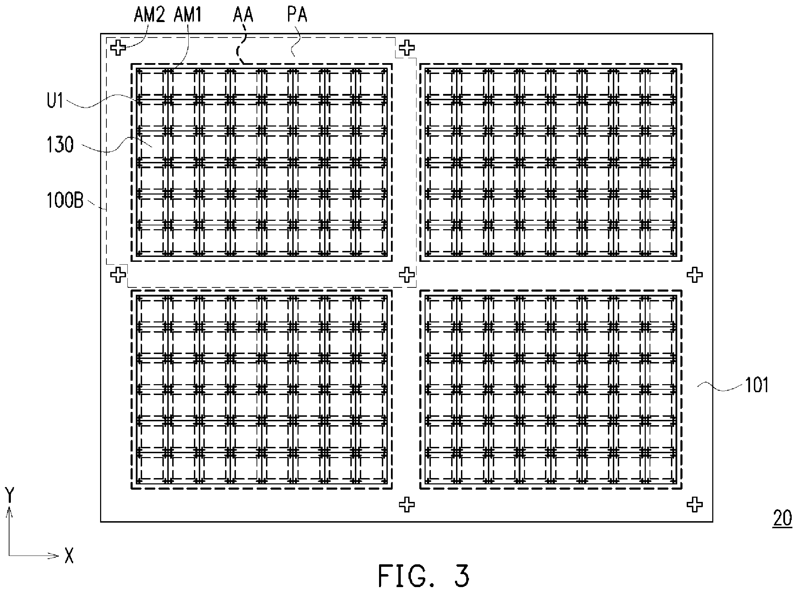

FIG. 3 is a schematic top view illustrating a display device according to another embodiment of the disclosure. Referring to FIG. 2 and 3 together, the display device 10 depicted in FIG. 2 and the display device 20 depicted in FIG. 3 is similar, the difference is that, for the display device 20 depicted in FIG. 3, each alignment region 100B of the display device 20 has a pair of the alignment marks AM2 located at two different positions on the non-display area which are positioning along a extending direction of a diagonal line of the display area AA, and each sub-pixel unit U1 has two pairs of the alignment marks AMI respectively located at four different positions on the sub-pixel unit U1 which are positioning along extending directions of two diagonal lines of the sub-pixel unit U1. In other words, the alignment marks AMI are respectively located at four corners of the sub-pixel unit U1.

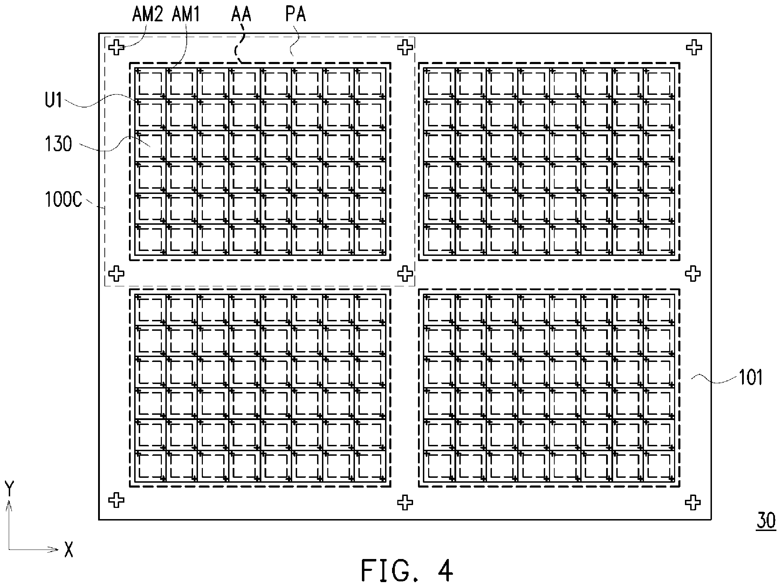

FIG. 4 is a schematic top view illustrating a display device according to another embodiment of the disclosure. Referring to FIG. 2 and 4 together, the display device 10 depicted in FIG. 2 and the display device 30 depicted in FIG. 4 is similar, the difference is that, for the display device 30 depicted in FIG. 4, each alignment region 100C of the display device 30 has two pair of the alignment marks AM2 respectively located at four different positions on the non-display area which are positioning along extending directions of two diagonal lines of the display area AA, and each sub-pixel unit U1 has a pair of the alignment marks AMI located at two different positions on the sub-pixel unit U1 which are positioning along an extending direction of a diagonal line of the sub-pixel unit U1. In other words, the alignment marks AM2 are respectively located at four corners of the alignment region 110C and on the non-display area.

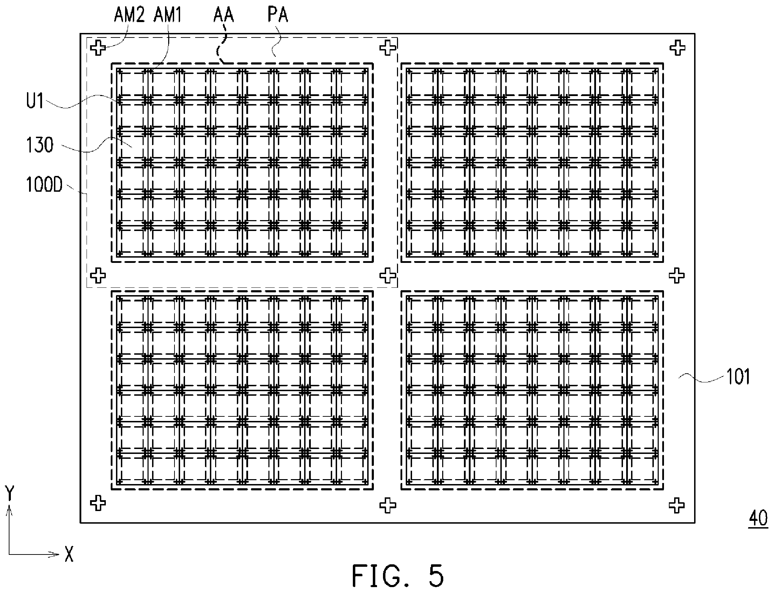

FIG. 5 is a schematic top view illustrating a display device according to another embodiment of the disclosure. Referring to FIG. 2 and 4 together, the display device 10 depicted in FIG. 2 and the display device 40 depicted in FIG. 5 is similar, the difference is that, for the display device 40 depicted in FIG. 5, each alignment region 100D of the display device 40 has two pair of the alignment marks AM2 respectively located at four different positions on the non-display area which are positioning along extending directions of two diagonal lines of the display area AA, and each sub-pixel unit U1 has two pairs of the alignment marks AMI respectively located at four different positions on the sub-pixel unit U1 which are positioning along extending directions of two diagonal lines of the sub-pixel unit U1.

Additionally, in some embodiments, the display device 10 may include an opposite substrate (not shown), wherein the opposite substrate may include a substrate having at least one of a color filter layer, a wavelength conversion layer, a black matrix layer, and other insulating layers, and the positioning configuration and materials of the above elements may be common known and may be designated and selected based on the demand by persons skilled in the art, and thus are omitted from illustration herein.

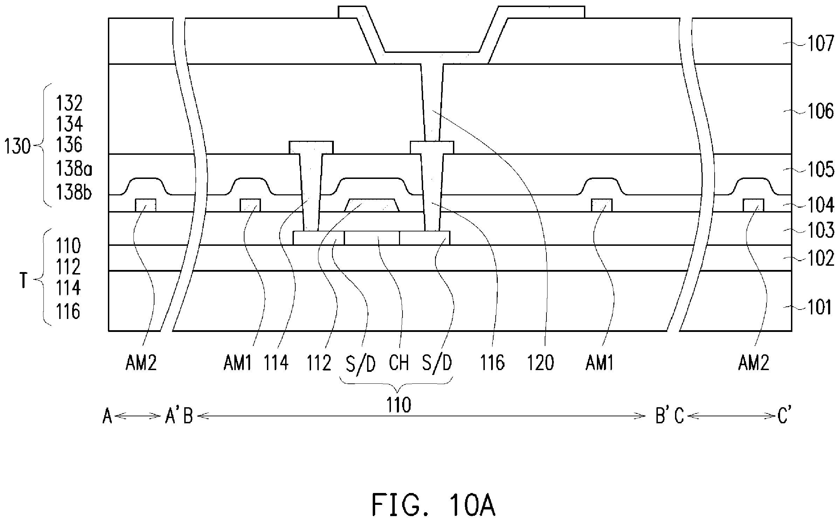

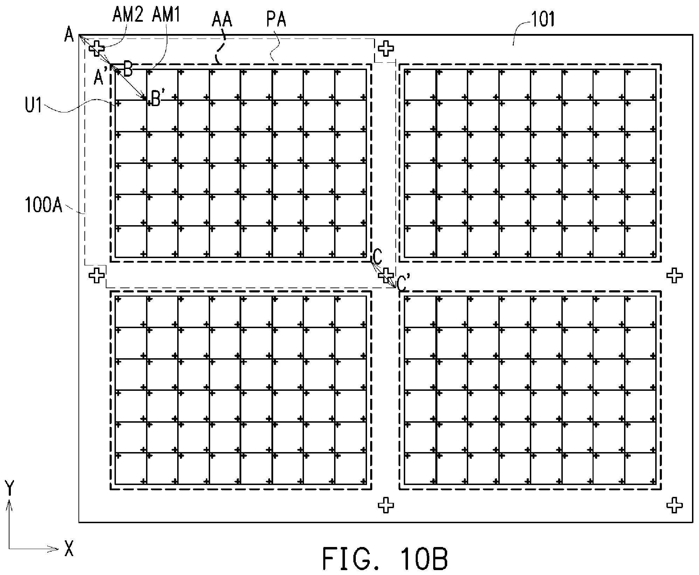

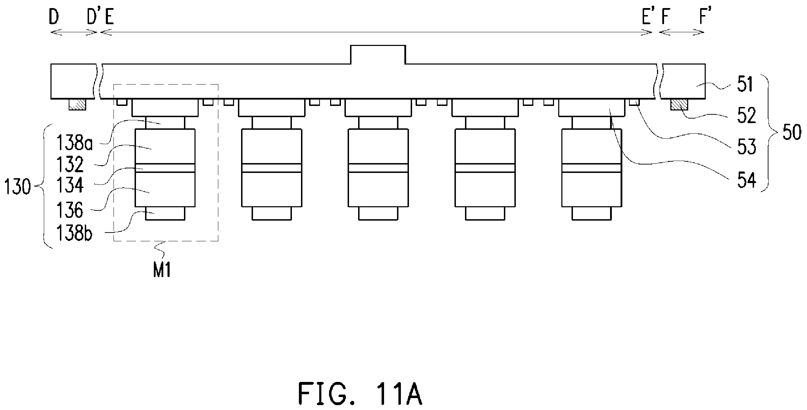

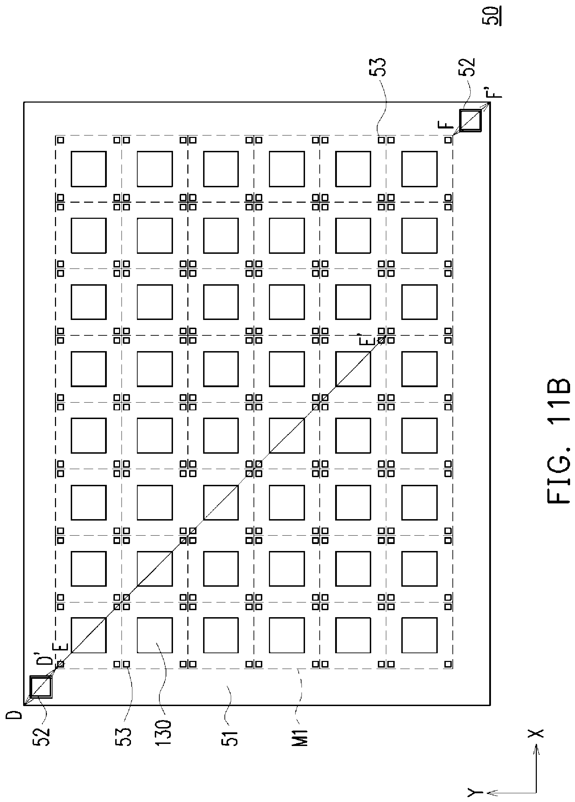

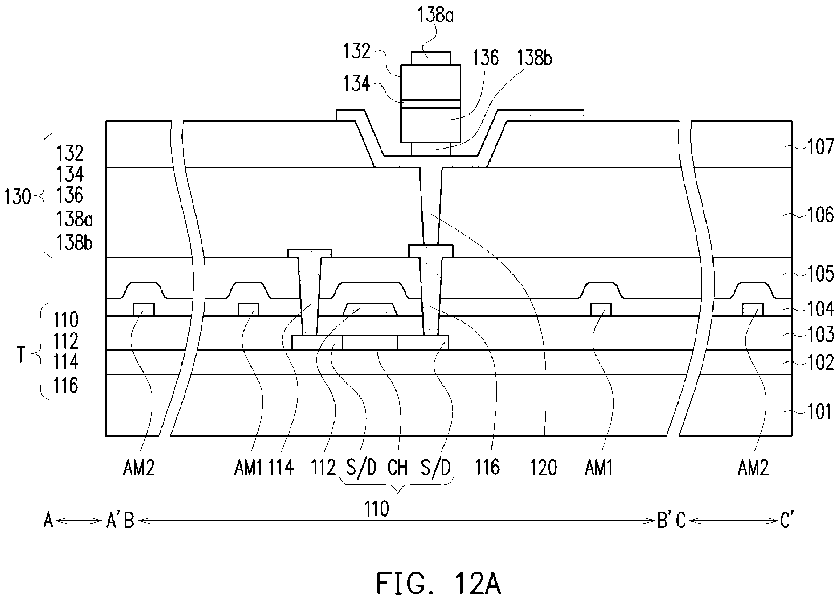

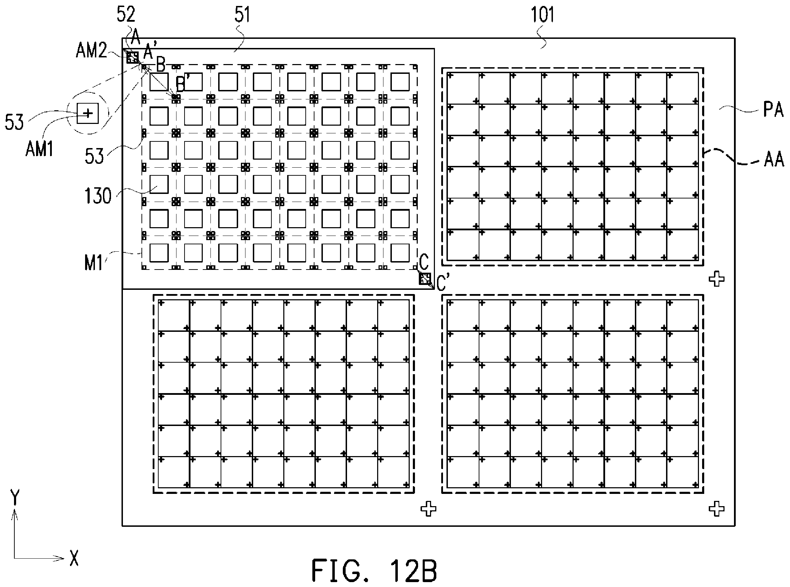

FIG. 10A is a schematic cross-sectional view of an intermediately stage in a manufacturing process of a display device according to a first embodiment of the disclosure. FIG. 10B is a schematic plane view of the display device depicted in FIG. 10A. FIG. 11A is a schematic cross-sectional view of a pick apparatus used in an intermediately stage in a manufacturing process of the display device according to the first embodiment of the disclosure. FIG. 11B is a schematic plane view of the pick apparatus depicted in FIG. 11A. FIG. 12A is a schematic cross-sectional view of an intermediately stage in a manufacturing process of the display device according to the first embodiment of the disclosure. FIG. 12B is a schematic plane view of the display device depicted in FIG. 12A.

FIG. 10A is a schematic cross-sectional view of an intermediately stage in a manufacturing process of the display device 10 depicted in FIG. 2 according to the first embodiment, and FIG. 10B is a plane view of the display device 10 depicted in FIG. 10A, wherein the cross-sectional view of FIG. 10A is taken along the section line A-A', the section line B-B' and the section line C-C' of FIG 10B. Referring to FIG. 10A and FIG. 10B together, the substrate 101 having the transistor T, the pixel electrode 120, the alignment marks AMI and the alignment marks AM2 is provided. In other words, the display unit 130, the insulating layer 108, the filling material 140, the conductive electrode 150, and the protection layer 109 are not yet formed on the substrate 101 of the display device 10 depicted in FIG. 2 and FIG. 6.

FIG. 11A is a schematic cross-sectional view of a pick apparatus 50 of an intermediately stage in a manufacturing process of the display device 10 according to the first embodiment, and FIG. 11B is a plane view of the pick apparatus 50 depicted in FIG. 11A, wherein the cross-sectional view of FIG. 11A is taken along the section line D-D', the section line E-E' and the section line F-F' of FIG. 11B. Referring to FIG. 11A and FIG. 11B together, the display units 130 temporarily stored in a form of array on a carrier substrate (not shown) are moved and picked by means of an array pick apparatus (e.g., the pick apparatus 50 as shown in FIG. 11A) to assemble with the substrate 101. In other words, the pick apparatus 50 moves a plurality of the display units 130 in an array manner.

In the embodiment, the pick apparatus 50 has a holder 51, alignment marks 52, alignment marks 53, and an array of pick heads 54, wherein the alignment marks 52, the alignment marks 53 and the pick heads 54 are disposed on the holder 51, and a pick action is performed by the pick heads 54 to prevent any fail display unit 130 being moved and disposed on the substrate 101. In the embodiment, as shown in FIG. 11A and FIG. 11B, the holder 51 of the pick apparatus 50 corresponds to one alignment region 100A of the substrate 101, wherein the holder 51 has a plurality of regions M1 arranged in an array along an X-direction and a Y-direction, and the array of the regions M1 corresponds to the array of sub-pixel units U1, where one region M1 is corresponding to one sub-pixel unit U1. In detail, at least two alignment marks 53 and at least one pick head 54 are located in each region M1, and at least two alignment marks 52 are located outside of the array of the regions M1. In the embodiment, each of the alignment marks 52 corresponds to one of the alignment marks AM2 of the substrate 101, and each of the alignment marks 53 corresponds to one of the alignment marks AMI.

FIG. 12A is a schematic cross-sectional view of an intermediately stage in a manufacturing process of the display device 10 according to the first embodiment, and the pick apparatus 50 is omitted in the cross-sectional view for clarification. FIG. 12B is a plane view of the display device 10 depicted in FIG. 12A, wherein the cross-sectional view of FIG. 12A is taken along the section line A-A', the section line B-B' and the section line C-C' of FIG 12B. As shown in FIG. 12A and FIG. 12B, a moving action is performed, the display units 130 are assembly with the substrate 101 accurately, wherein one of the display units 130 is electrically connected to the corresponding transistor T through the pixel electrode 120.

In the embodiment, by the moving action, the regions M1 of the holder 51, the alignment marks 52, and the alignment marks 53 are aligned with the sub-pixel units U1, the alignment marks AM2, and the alignment marks AMI, respectively. Owing to the positioning configurations between the alignment marks 52 and the alignment marks AM2 and between the alignment marks 53 and the alignment marks AMI, the display units 130 can be assembly with the substrate 101 accurately. In detail, the aligning manner between the alignment marks AMI and the alignment marks 53 and the aligning manner between the alignment marks AM2 and the alignment marks 52 can be easily performed by using an optical microscope (e.g. a detection of an intensity of light reflection of the alignment marks AMI and/or the alignment marks AM2). Since the locations of the alignment marks AMI and the alignment marks AM2 are determined, the alignment marks 53 and the alignment marks 52 can rapidly aligns the alignment marks AMI and the alignment marks AM2, respectively. As such, a better accuracy of transferring display units onto a substrate and a less required time for transferring the display units during the fabrication can be achieved.

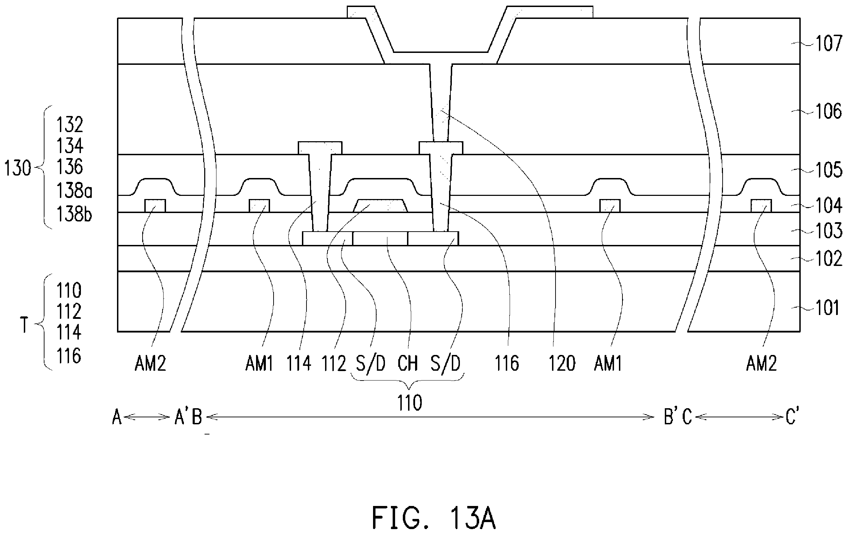

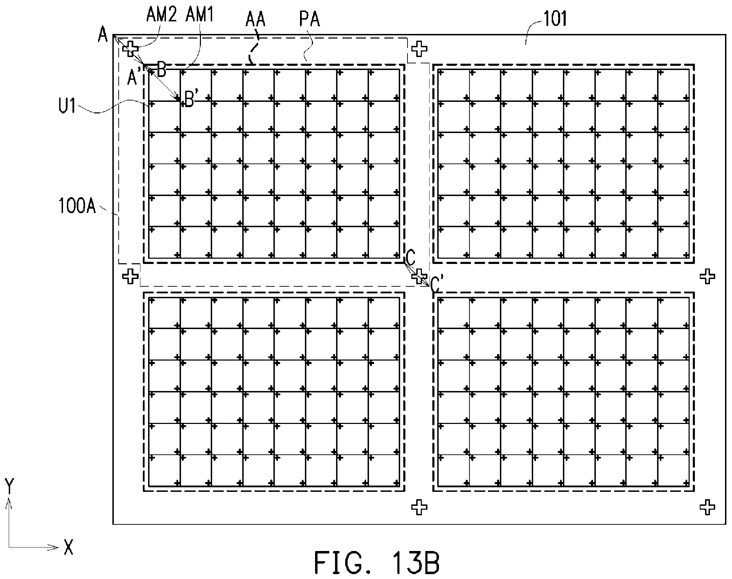

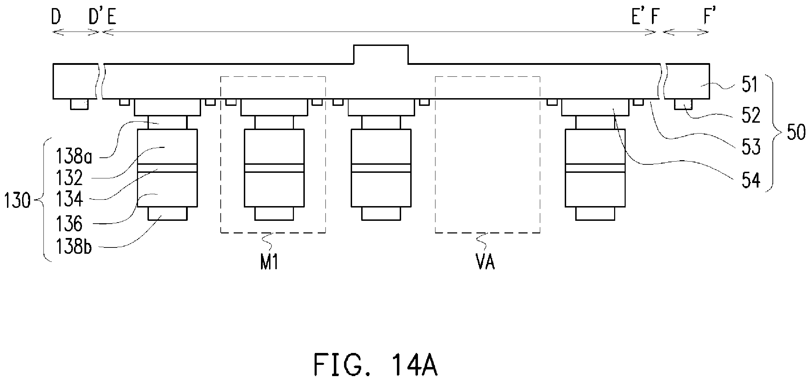

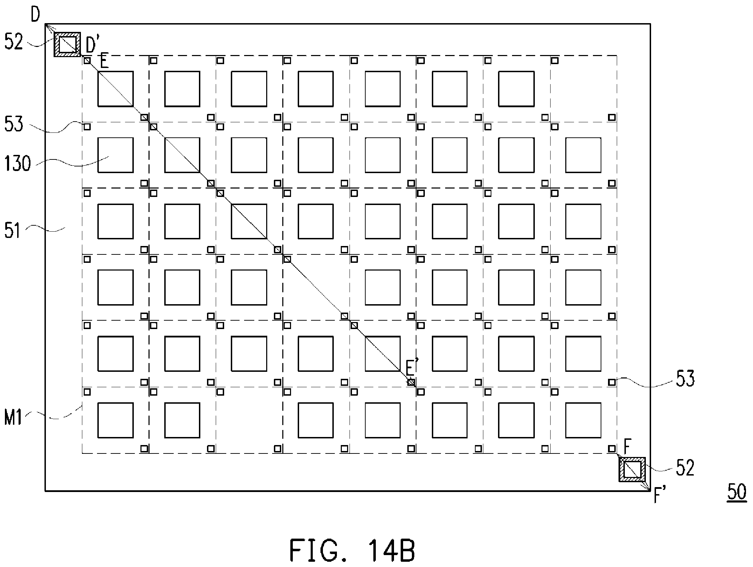

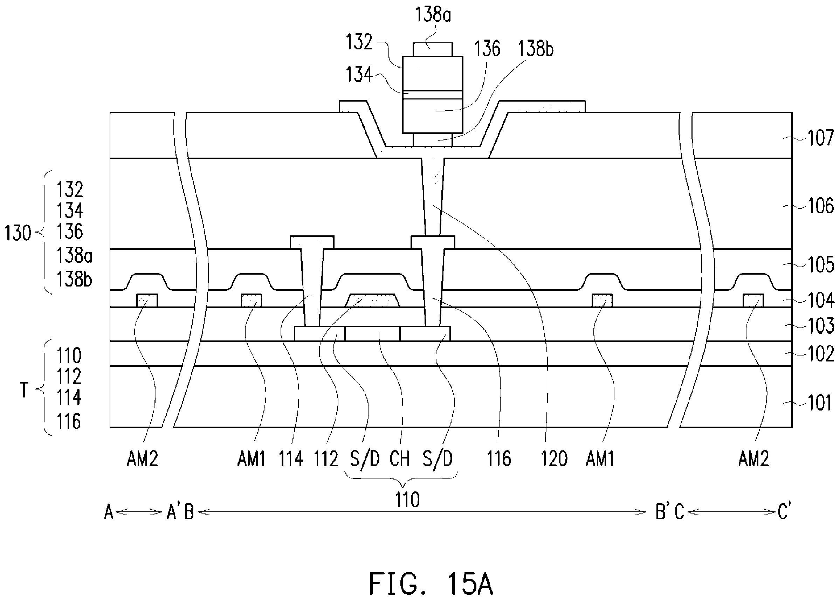

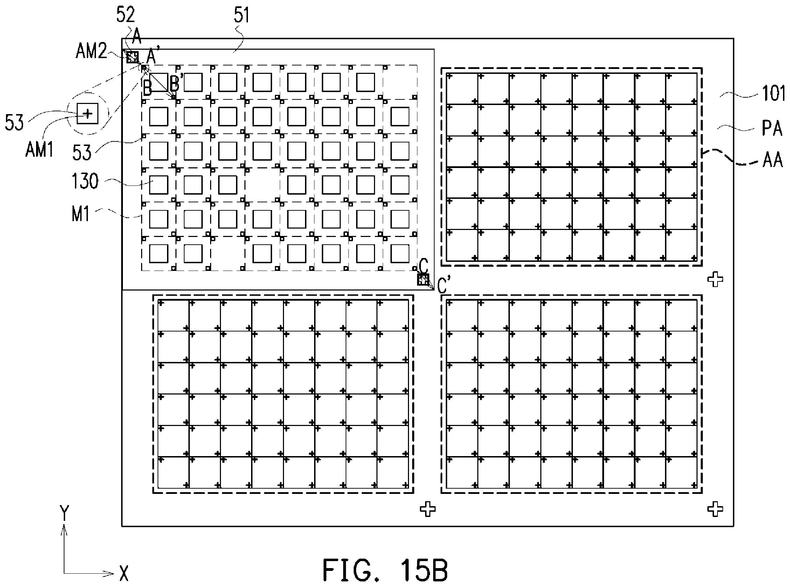

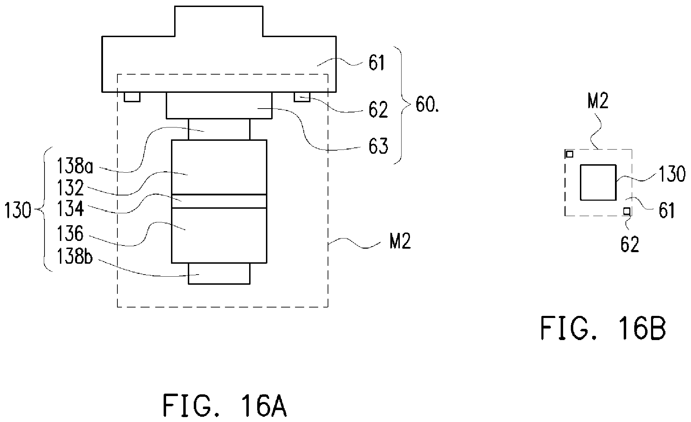

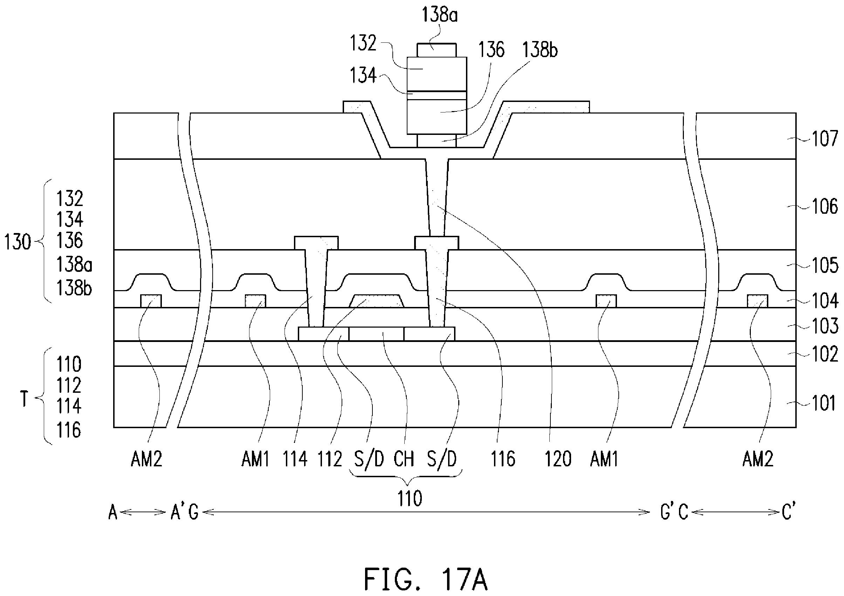

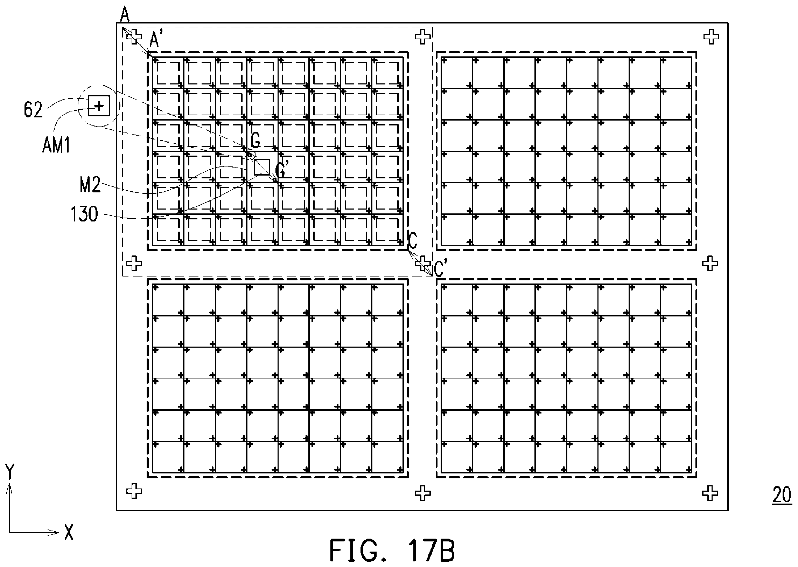

FIG. 13A is a schematic cross-sectional view of an intermediately stage in a manufacturing process of a display device according to a second embodiment of the disclosure. FIG. 13B is a schematic plane view of the display device depicted in FIG. 13A. FIG. 14A is a schematic cross-sectional view of a pick apparatus used in an intermediately stage in a manufacturing process of a display device according to the second embodiment of the disclosure. FIG. 14B is a schematic plane view of the pick apparatus depicted in FIG. 14A. FIG. 15A is a schematic cross-sectional view of an intermediately stage in a manufacturing process of the display device according to the second embodiment of the disclosure. FIG. 15B is a schematic plane view of the display device depicted in FIG. 15A. FIG. 16A is a schematic cross-sectional view of a pick apparatus used in an intermediately stage in a manufacturing process of the display device according to the second embodiment of the disclosure. FIG. 16B is a schematic plane view of the pick apparatus depicted in FIG. 16A. FIG. 17A is a schematic cross-sectional view of an intermediately stage in a manufacturing process of the display device according to the second embodiment of the disclosure. FIG. 17B is a schematic plane view of the display device depicted in FIG. 17A.

FIG. 13A is a schematic cross-sectional view of an intermediately stage in a manufacturing process of the display device 10 depicted in FIG. 2 according to the second embodiment, and FIG. 13B is a plane view of the display device 10 depicted in FIG. 13A, wherein the cross-sectional view of FIG. 13A is taken along the section line A-A', the section line B-B' and the section line C-C' of FIG 13B. Referring to FIG. 13A and FIG. 13B together, the substrate 101 having the transistor T, the pixel electrode 120, the alignment marks AMI and the alignment marks AM2 is provided. In other words, the display unit 130, the insulating layer 108, the filling material 140, the conductive electrode 150, and the protection layer 109 are not yet disposed on the substrate 101 of the display device 10 depicted in FIG. 2 and FIG. 6.

FIG. 14A is a schematic cross-sectional view of a pick apparatus 50 of an intermediately stage in a manufacturing process of the display device 10 according to the second embodiment, and FIG. 14B is a plane view of the pick apparatus 50 depicted in FIG. 14A, wherein the cross-sectional view of FIG. 14A is taken along the section line D-D', the section line E-E' and the section line F-F' of FIG. 14B. Referring to FIG. 14A and FIG. 14B together, the display units 130 temporarily stored in a form of an array on a carrier substrate (not shown) are moved and picked by means of an array pick apparatus (e.g., the pick apparatus 50) to assemble with the substrate 101. In the embodiment, a few of the display units 130 are damaged or malfunctioned and thus are dismissed from the array of the display units 130 that is moved via the pick apparatus 50 by a pick action. In other words, the pick apparatus 50 moves a plurality of the display units 130 in an array manner, where the damaged and/or malfunctioned display units 130 are not picked and thus resulting vacancies VA (see FIG. 14B) may be presented in the array of the display units 130 moved and picked by the pick apparatus 50.

In the embodiment, the pick apparatus 50 of FIG. 14A and FIG. 14B has a holder 51, alignment marks 52, alignment marks 53, and an array of pick heads 54, wherein the alignment marks 52, the alignment marks 53 and the pick heads 54 are disposed on the holder 51, and a pick action is performed by the pick heads 54 to prevent any fail display unit 130 being moved and disposed on the substrate 101. In the embodiment, as shown in FIG. 14A and FIG. 14B, the holder 51 of the pick apparatus 50 corresponds to one alignment region 100A of the substrate 101, wherein the holder 51 has a plurality of regions M1 arranged in an array along an X-direction and a Y-direction, and the array of the regions M1 corresponds to the array of sub-pixel units U1, where one region M1 is corresponding to one sub-pixel unit U1. In detail, at least two alignment marks 53 and at least one pick head 54 are located in one region M1, and the at least two alignment marks 52 are located outside of the array of the regions M1, wherein each of the alignment marks 52 corresponds to one of the alignment marks AM2 of the substrate 101, and each of the alignment marks 53 corresponds to one of the alignment marks AMI.

FIG. 15A is a schematic cross-sectional view of an intermediately stage in a manufacturing process of the display device 10 according to the second embodiment, and the pick apparatus 50 is omitted in the cross-sectional view for clarification. FIG. 15B is a plane view of the display device 10 depicted in FIG. 15A, wherein the cross-sectional view of FIG. 15A is taken along the section line A-A', the section line B-B' and the section line C-C' of FIG 15B. As shown in FIG. 15A and FIG. 15B, a moving action is performed, the display units 130 are assembly with the substrate 101 accurately, wherein one of the display units 130 is electrically connected to the corresponding transistor T through the pixel electrode 120.

In the embodiment, by the moving action, the regions M1 of the holder 51, the alignment marks 52, and the alignment marks 53 are aligned with the sub-pixel units U1, the alignment marks AM2, and the alignment marks AMI, respectively. Owing to the positioning configurations between the alignment marks 52 and the alignment marks AM2 and between the alignment marks 53 and the alignment marks AMI, the display units 130 can be assembly with the substrate 101 accurately. In detail, the aligning manner between the alignment marks AMI and the alignment marks 53 and the aligning manner between the alignment marks AM2 and the alignment marks 52 can be easily performed by using an optical microscope (e.g. a detection of an intensity of light reflection of the alignment marks AMI and/or the alignment marks AM2). Since the locations of the alignment marks AMI and the alignment marks AM2 are determined, the alignment marks 53 and the alignment marks 52 can rapidly aligns the alignment marks AMI or the alignment marks AM2, respectively. As such, a better accuracy of transferring display units onto a substrate and a less required time for transferring the display units during the fabrication can be achieved.

FIG. 16A is a schematic cross-sectional view of a pick apparatus 60 of an intermediately stage in a manufacturing process of the display device 10 according to the second embodiment, and FIG. 16B is a plane view of the pick apparatus 60 depicted in FIG. 16A. Referring to FIG. 16A and FIG. 16B together, one of the display units 130 temporarily stored in a form of array on a carrier substrate (not shown) are individually moved and picked by means of a single pick apparatus (e.g., the pick apparatus 60) to assemble with the substrate. That is, differing from the pick apparatus 50 moving a plurality of the display units 130 in an array manner, the pick apparatus 60 moves one display unit 130 at one time.

In detail, the pick apparatus 60 of FIG. 16A and FIG. 16B has a holder 61, at least two alignment marks 62, and a pick head 63, wherein the alignment marks 62 and the pick head 63 are disposed on the holder 61, and a pick action is performed by the pick head 63 to prevent any fail display unit 130 being moved and disposed on the substrate 101. In the embodiment, the at least two of the alignment marks 62 and the pick head 63 are located in a region M2 of the pick apparatus 60, and the region M2 corresponds to one sub-pixel unit U1, wherein each of the alignment marks 62 corresponds to one of the alignment marks AMI.

FIG. 17A is a schematic cross-sectional view of an intermediately stage in a manufacturing process of the display device 10 according to the first embodiment, and the pick apparatus 50 is omitted in the cross-sectional view for clarification. FIG. 17B is a plane view of the display device 10 depicted in FIG. 17A, wherein the cross-sectional view of FIG. 17A is taken along the section line A-A', the section line G-G' and the section line C-C' of FIG 17B. As shown in FIG. 17A and FIG. 17B, a moving action is performed, the display unit 130 is assembly with the substrate 101 accurately, wherein the display unit 130 is electrically connected to the corresponding transistor T through the pixel electrode 120.

In the embodiment, by the moving action, the regions M2 of the holder 61 and the alignment marks 62 are aligned with the sub-pixel units U1 and the alignment marks AMI, respectively. Owing to the positioning configurations between the alignment marks 62 and the alignment marks AMI, the display unit 130 can be assembly with the substrate 101 accurately. In detail, the aligning manner between the alignment marks AMI and the alignment marks 62 can be easily performed by using an optical microscope (e.g. a detection of an intensity of light reflection of the alignment marks AM1). Since the locations of the alignment marks AMI are determined, the alignment marks 62 can rapidly aligns the alignment marks AMI, respectively. As such, a better accuracy of transferring display units onto a substrate and a less required time for transferring the display units during the fabrication can be achieved. In addition, the step of FIG. 17A and FIG. 17B can be repeated by several times to ensure each sub-pixel unit U1 has one display unit 130.

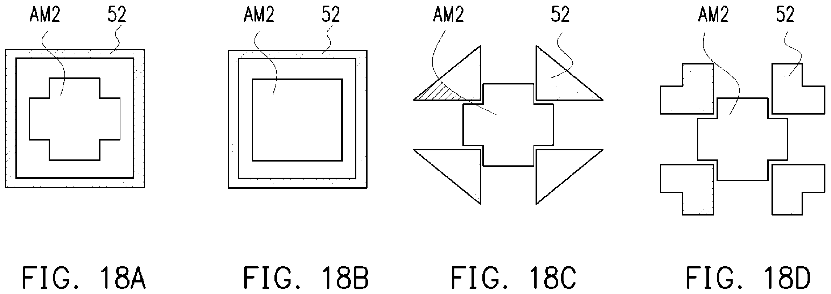

FIG. 18A to FIG. 18D are schematic top views of a relative position between an alignment mark disposed on a display panel and an alignment mark disposed on a pick apparatus. The alignment mark AM2 may be, for example, a cross-shaped, or a square or a rectangular shaped. On the other hand, the alignment mark 52 may include, for example, a hollow square or rectangular shape, a plurality of triangular shaped portions, or a plurality of L-shaped portions. As shown in FIG. 18A an FIG. 18B, the alignment mark 52 surrounds the alignment mark AM2. As shown in FIG. 18C an FIG. 18D, the alignment mark 52 partially overlaps the alignment mark AM2. Furthermore, the alignment marks AMI can have the same shape as the alignment mark AM2, and the alignment marks 53 and the alignment marks 62 can have the same shape as the alignment mark 52. However, the disclosure is not limited thereto.

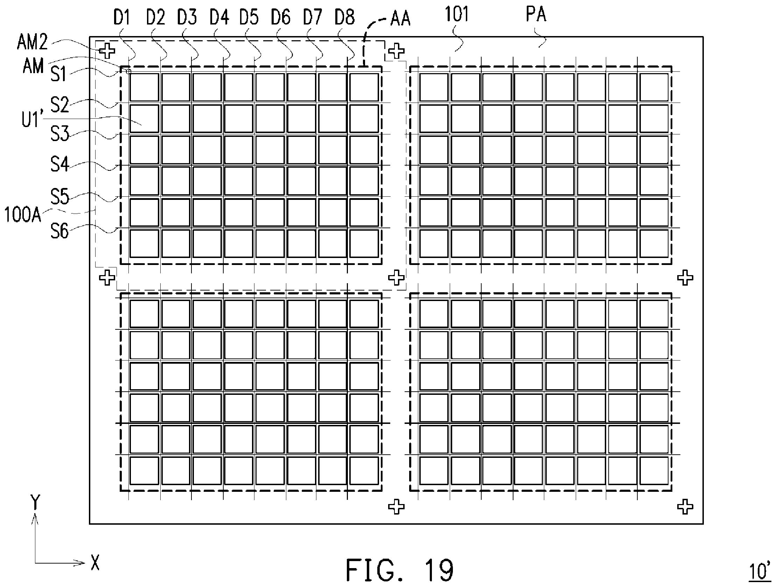

Additionally, FIG. 19 is a schematic top view illustrating a display device according to another embodiment of the disclosure. Referring to FIG. 2 and FIG. 19 together, the display device 10' of FIG. 19 is similar to the display devices 10 of FIG. 2; therefore, the identical or similar element in these embodiments are represented by the identical or similar reference numbers and will not be further explained. The difference is that, the sub-pixel units U1' of the display device 10' depicted in FIG. 19 has replaced the alignment marks AMI with intersections of data lines (e.g., data lines D1∼D8) and scan lines (e.g., scan lines S1∼S8) as indicated by AM. In other words, the display device 10' of FIG. 19 is similar to the display device 10 of FIG. 2, the difference is that, the display device 10' has only the alignment marks AM2. With such configuration, a simple calculation is performed to locate a specific intersection of one of the scan lines S1∼S6 and one of the data lines D1∼D8, so that each the display unit 130 can be disposed on the corresponding transistor T accurately.

Based on the above, in the display device of the disclosure, owing to the presence(s) of the alignment marks disposed on the non-display area and/or disposed on the display area, a better accuracy of transferring display units onto a substrate of the display device and a less required time for transferring the display units during the manufacturing process are achieved.

## Claims

1. A display device, comprising:
a substrate (101), comprising a display area (AA) and a non-display area (PA) adjacent to the display area (AA);
a plurality of transistors (T), disposed on the display area (AA) of the substrate (101);
a plurality of display units (130), disposed on the display area (AA) of the substrate (101) and electrically connected to the plurality of transistors (T), wherein the plurality of display units (130) are light emitting diodes;
a plurality of alignment marks (AM1/AM2), disposed on the substrate (101); and
a plurality of sub-pixel units (U1/U1') arranged in an array within the display area (AA), wherein each pixel comprises a transistor (T) from the plurality of transistors, the transistor comprising a gate electrode (112) and a source/drain electrode (114/116) and a display unit (130) from the plurality of display units and
wherein the display device is **characterized in that**
each of the plurality of sub-pixel units (U1) has a pair of alignment marks (AM1) of the plurality of alignment marks (AM1) located at two different positions on the sub-pixel unit (U1) which are positioned along an extending direction of a diagonal line of the sub-pixel unit (U1), and
the plurality of alignment marks (AM1/AM2) and the gate electrode (112) are formed in the same layer and comprise the same material; or the plurality of alignment marks (AM1/AM2) and the source/drain electrode (114/116) are formed in the same layer and comprise the same material.

2. The display device according to claim 1, wherein at least another one of the plurality of alignment marks (AM2) is disposed on the non-display area (PA) of the substrate (101).

3. The display device according to any of the claims 1 to 2, further comprising:
an insulating layer (106, 107), disposed on the plurality of transistors (T), and the insulating layer (106, 107) including an opening; and
a pixel electrode (120), disposed in the opening and electrically connected to at least one of the plurality of display units (130).

4. The display device according to any of the claims 1 to 2, wherein a number of the plurality of display units (130) is greater than a number of the plurality of alignment marks (AM1/AM2) disposed on the display area (AA) of the substrate (101).

5. The display device according to any of the claims 1 to 4, wherein the plurality of alignment marks (AM1/AM2) and the plurality of display units (130) are not overlapping.

6. The display device according to claim 1, wherein in each sub-pixel the display unit (130) is disposed on the transistor (T) and electrically connected to the transistor (T) through a pixel electrode (120), and the plurality of the plurality of display units (130) are micro light emitting diodes.

## Patentansprüche

1. Anzeigevorrichtung, umfassend:
ein Substrat (101), das einen Anzeigebereich (AA) und einen an den Anzeigebereich (AA) angrenzenden Nicht-Anzeigebereich (PA) umfasst;
eine Vielzahl von Transistoren (T), die auf der Anzeigefläche (AA) des Substrats (101) angeordnet sind,
eine Vielzahl von Anzeigeeinheiten (130), die auf dem Anzeigebereich (AA) des Substrats (101) angeordnet und elektrisch mit der Vielzahl von Transistoren (T) verbunden sind, wobei die Vielzahl von Anzeigeeinheiten (130) Leuchtdioden sind;
eine Vielzahl von Ausrichtungsmarkierungen (AM1/AM2), die auf dem Substrat (101) angeordnet sind; und
eine Vielzahl von Sub-Pixel-Einheiten (U1/U1'), die in einem Array innerhalb des Anzeigebereichs (AA) angeordnet sind, wobei jedes Pixel einen Transistor (T) aus der Vielzahl von Transistoren umfasst, wobei der Transistor eine Gate-Elektrode (112) und eine Source/Drain-Elektrode (114/116) und eine Anzeigeeinheit (130) aus der Vielzahl von Anzeigeeinheiten umfasst, und
wobei die Anzeigevorrichtung **dadurch gekennzeichnet ist, dass**
jede der Vielzahl von Subpixel-Einheiten (U1) ein Paar von Ausrichtungsmarkierungen (AM1) der Vielzahl von Ausrichtungsmarkierungen (AM1) aufweist, die sich an zwei verschiedenen Positionen auf der Subpixel-Einheit (U1) befinden, die entlang einer Erstreckungsrichtung einer diagonalen Linie der Subpixel-Einheit (U1) angeordnet sind, und
wobei die Vielzahl von Ausrichtungsmarkierungen (AM1/AM2) und die Gate-Elektrode (112) in derselben Schicht ausgebildet sind und dasselbe Material aufweisen; oder die mehreren Ausrichtungsmarkierungen (AM1/AM2) und die Source-/Drain-Elektrode (114/116) in derselben Schicht ausgebildet sind und dasselbe Material aufweisen.

2. Anzeigevorrichtung nach Anspruch 1, wobei mindestens eine weitere der mehreren Ausrichtungsmarkierungen (AM2) auf dem Nicht-Anzeigebereich (PA) des Substrats (101) angeordnet ist.

3. Anzeigevorrichtung nach einem der Ansprüche 1 bis 2, ferner umfassend:
eine Isolierschicht (106, 107), die auf der Vielzahl von Transistoren (T) angeordnet ist, wobei die Isolierschicht (106, 107) eine Öffnung aufweist; und
eine Pixelelektrode (120), die in der Öffnung angeordnet und mit mindestens einer der mehreren Anzeigeeinheiten (130) elektrisch verbunden ist.

4. Anzeigevorrichtung nach einem der Ansprüche 1 bis 2, wobei eine Anzahl der mehreren Anzeigeeinheiten (130) größer ist als eine Anzahl der mehreren Ausrichtungsmarkierungen (AM1/AM2), die auf dem Anzeigebereich (AA) des Substrats (101) angeordnet sind.

5. Anzeigevorrichtung nach einem der Ansprüche 1 bis 4, wobei sich die Vielzahl der Ausrichtungsmarkierungen (AM1/AM2) und die Vielzahl der Anzeigeeinheiten (130) nicht überlappend sind.

6. Anzeigevorrichtung nach Anspruch 1,
wobei in jedem Subpixel die Anzeigeeinheit (130) auf dem Transistor (T) angeordnet ist und elektrisch mit dem Transistor (T) über eine Pixelelektrode (12) verbunden ist, und die Mehrzahl der Vielzahl von Anzeigeeinheiten (130) Mikro-Leuchtdioden sind.

## Revendications

1. Un dispositif d'affichage, comprenant :
un substrat (101), comprenant une zone d'affichage (AA) et une zone de non-affichage (PA) adjacente à la zone d'affichage (AA) ;
une pluralité de transistors (T), disposés sur la zone d'affichage (AA) du substrat (101);
une pluralité d'unités d'affichage (130), disposées sur la zone d'affichage (AA) du substrat (101) et connectées électriquement à la pluralité de transistors (T), dans lequel la pluralité d'unités d'affichage (130) sont des diodes électroluminescentes ;
une pluralité de repères d'alignement (AM1/AM2), disposés sur le substrat (101) ; et
une pluralité d'unités de sous-pixel (U1/U1') disposées dans une matrice à l'intérieur de la zone d'affichage (AA), dans laquelle chaque pixel comporte un transistor (T) de la pluralité de transistors, le transistor comprenant une électrode de grille (112) et une électrode de drain/source (114/116) et une unité d'affichage (130) au sein de la pluralité d'unités d'affichage et
dans lequel le dispositif d'affichage est **caractérisé en ce que**
chaque unité de la pluralité d'unités de sous-pixels (U1) a une paire de repères d'alignement (AM1) au sein de la pluralité de repères d'alignement (AM1) située à deux positions sur l'unité de sous-pixel (U1) qui sont positionnées le long d'une direction d'extension d'une ligne diagonale de l'unité de sous-pixel (U1), et
la pluralité de repères d'alignement (AM1/AM2) et l'électrode de grille (112) sont formées dans la même couche et comporte le même matériau ; ou la pluralité de repères d'alignement (AM1/AM2) et l'électrode de source/drain (114/116) sont forme au sein de la même couche et comporte le même matériau.

2. Le dispositif d'affichage selon la revendication 1, dans lequel au moins un autre de la pluralité de repères d'alignement (AM2) est disposé sur la zone de non-affichage (PA) du substrat (101).

3. Le dispositif d'affichage selon la revendication 1 ou 2, comprenant en outre :
une couche isolante (106, 107), disposée sur la pluralité de transistors (T), et la couche isolante (106, 107) comprenant une ouverture ; et
une électrode de pixel (120), disposée dans l'ouverture et connectée électriquement à au moins l'une de la pluralité d'unités d'affichage (130).

4. Le dispositif d'affichage selon l'une quelconque des revendications 1 à 2, dans lequel un nombre de la pluralité d'unités d'affichage (130) est supérieur à un nombre de la pluralité de repères d'alignement (AM1/AM2) disposés sur la zone d'affichage (AA) de le substrat (101).

5. Le dispositif d'affichage selon l'une quelconque des revendications 1 à 4, dans lequel la pluralité de repères d'alignement (AM1/AM2) et la pluralité d'unités d'affichage (130) ne se chevauchent pas.

6. Le dispositif d'affichage selon la revendication 1,
dans lequel au sein de chaque sous-pixel, l'unité d'affichage (130) est disposée sur le transistor (T) et connectée électriquement au transistor (T) via une électrode de pixel (120), et la pluralité d'unités d'affichage (130) sont des micro-diodes électroluminescentes.
